# EUROPEAN PATENT APPLICATION

(11) **EP 0 802 033 A1**
(43) Date of publication of application: **22.10.1997**
(21) Application number: 97301675.1
(22) Date of filing: 12.03.1997
(51) Int. Cl.: B29C 47/02, B29C 47/06, H05K 9/00

(54) **Method for providing electromagnetic shielding and diffusion barrier properties of plastic extrusion and devices fabricated therefrom**

(30) Priority: 25.03.1996 US 620736
(71) Applicant: LUCENT TECHNOLOGIES INC., Murray Hill, New Jersey 07974-0636 (US)
(72) Inventor: Lambert, William Roger, Chester, New Jersey 07930 (US); Weld, John David, Succasunna, New Jersey 07876 (US)
(74) Representative: Johnston, Kenneth Graham

(57) **Abstract**

A method for fabricating a coextruded part includes a multiple layer sheet. First, an extruded part (80) is fabricated which can include a complex interior structure. Then, a multiple layer sheet material (82) is formed into a tube surrounding the first extruded part (80) and bonded to the outer surface. Next, the composite structure then enters a second extrusion die (40) and an outer layer of a second polymeric material (84) is coextruded over the structure to form the outer surface. Thus, the multiple layer sheet (82) embedded within the coextruded part imparts diffusion barrier and electromagnetic shielding capabilities to a complex extruded part in a continuous and cost effective manner.

## Description

### BACKGROUND OF THE INVENTION

### 1. Field of the Invention

The invention relates to a method for applying multiple layer sheets onto the surface of or embedded within a plastic extrusion to provide electromagnetic shielding and diffusion barrier properties to the complex part.

### 2. Description of Related Art

Extrusion is a process in which heated or unheated plastic is forced through a shaping orifice, known as a die, in one continuous formed shape as in film, sheet, pipe, profile, etc. (see for example, D.V. Rosato, **Rosato's Plastic Encyclopedia and Dictionary**, Hanser Publishers, New York, 1993, pp. 239-270). Plastic extrusion is an economical, versatile and well-developed technology which allows for the processing of variable thickness, multichanneled cross-sections for structural rigidity and efficient use of materials. Products fabricated by means of plastic extrusion are widely used in the building industry (e.g., vinyl siding, gutters, downspouts, ridge vents, pipe, window frames, docks and fences), and automotive industry (e.g., mouldings and trim features). For many applications, the desired attributes of the final part cannot be fully achieved with a single plastic material. The technologies of coextrusion and lamination have been developed to augment the capabilities of a part fabricated using a single plastic material.

Coextrusion involves the laminar combination of two or more materials in the form of a melt to produce a composite multiple layer structure (see for example, D.V. Rosato, **Rosato's Plastic Encyclopedia and Dictionary,** Hanser Publishers, New York, 1993, pp. 119). Bonding between the layers is accomplished by means of heat or adhesives. Various dies (e.g., feed block and multiple manifold) and orientations (e.g., in-line, crosshead, angle head and offset) have been developed to implement plastic coextrusion. Coextrusion allows for multiple materials to be processed concurrently providing the use of, for example, a low-cost, thick structural internal material layer and a thin external material layer for aesthetics, abrasion resistance, weatherability and the like.

The process of lamination can also be used to produce a multiple component structure. The process of lamination is primarily distinguished by the fact that the materials are not combined as a molten phase, although the materials may become molten during the lamination process. In lamination to an extruded part, a film (defined by convention as being no greater than 0.010 inches thick) or sheet (defined by convention as being greater than 0.010 inches thick) is bonded to the surface of the extruded part by thermal, mechanical, chemical or other means known to those skilled in the art. Laminating multiple plastic extruded films and/or sheets in combination with metal foils, paper, wood products, etc, is widely used to fabricate materials with overall properties enhanced by the attributes of each respective constitutive layer.

When a film is laminated to a part, the film is necessarily on the outer surface. In some applications, specifically where the surface properties are important, the film is optimally situated. When the integrity or performance of the film can be compromised by physical, chemical or other damage, it is inappropriate to use a laminated surface film. Imparting, for example, abrasion resistance to the film surface can add prohibitive expense.

Coextruded and/or laminated, multiple layer films and sheets can be very sophisticated depending upon the application and include capabilities that enhance the aesthetics, abrasion resistance, solvent resistance, weatherability, and the like of the completed part. One widespread application of extruded and/or multiple layer sheet and film is in the food packaging industry where materials comprising individual layers are selected for specific barrier, chemical resistance and aesthetic properties. Multiple layer composites designed for diffusion barrier applications may comprise bonding and metal layers. Examples of common commercial coextruded composite structures for consumer product and food packaging applications contain layers of materials such as polypropylene, polyethylene, polycarbonate, polyvinylidene chloride, ethylene vinyl alcohol copolymer, ionomers, polyester and polyamide. Specific materials function as superior diffusion barriers to water vapor and gas (nitrogen, oxygen, carbon dioxide, etc.). For other applications multiple layer sheets and films are designed to serve as diffusion barriers to corrosive and biological species. A comparative list of barrier material permeability characteristics for water vapor and gas can be found in, for example, D.V. Rosato, **Rosato's Plastic Encyclopedia and Dictionary,** Hanser Publishers, New York, 1993, pages 42-44. The design and fabrication of multiple layer sheets and films for specific applications is well known to those skilled in the art.

Diffusion barrier properties of multiple layer sheets and films can be substantially augmented by incorporation of metal films. For example, aluminum films with a thickness of greater than 0.0015 inches are typically pinhole free and are therefore impermeable to gases and vapors (see for example, D.V. Rosato, **Rosato's Plastic Encyclopedia and Dictionary,** Hanser Publishers, New York, 1993, pages 41 and 48). The medullization of polymeric materials can be accomplished by electroless plating, flame and arc spraying, sputtering and vacuum medullization processes to produce metal film thicknesses of from 0.01 to 3 mils. In addition to providing a diffusion barrier, by virtue of the inherent electrical conductivity, metal films enable electromagnetic interference (EMI) shielding capability. EMI and radio frequency interference (RFI) shielding capability are achieved with materials which exhibit a surface conductivity of 10⁵ Ω/square or less. However, for many emerging telecommunications applications where the transmission frequency is typically 1 GHz and above, surface resistivities of 1 Ω/square or less are required for effective EMI shielding. This can easily be accomplished with metal films and foils provided that effective sealing methods are employed.

While laminated and extruded multiple layer films have been applied to extruded plastic structural parts for many reasons including aesthetics, weatherability, abrasion resistance, etc., heretofore, applications have not indicated the need for enhanced diffusion barrier and EMI shielding properties. Furthermore, laminated and coextruded multiple layer films have only been applied to the surface of an extruded plastic part, and these, only on essentially two-dimensional parts (e.g. sheets) with low-profile surfaces.

Applications can be envisioned where the surface properties of an extruded part can be obtained by other means (for example coating, painting, etc.) or is otherwise adequate as fabricated. However, as previously stated, the use of a multiple layer film can still impart desirable characteristics. This can be especially true in parts which enclose an internal volume such as a pipe, enclosure or container. In certain applications, it may be desirable to enhance the barrier properties to gases, water vapor or biological species of a tubular structure by means of a multiple layer sheet. In addition, it may be desirable to provide a continuous conductive layer for electromagnetic interference (EMI) or electrostatic dissipative (ESD) shielding purposes. Furthermore, in some applications, it may not be advantageous to have the multiple layer sheet on either the outside or inside surface of the part, where it would be more susceptible to damage or wear. Also, due to complications associated with conformability of the sheet to complex topographies, efficient use of the multiple layer sheet is restricted to surfaces with smooth or very low profiles. It may be desirable to enhance the properties of a part that has surfaces with complex or high profile features. For the products previously discussed, one approach to employing the benefits of a multiple layer sheet is to embed the sheet within the body of the structural part.

Applications for plastic extrusions with enhanced diffusion barrier and EMI shielding capabilities are emerging in the electronics industry where portable, remote and sophisticated electronics are becoming ubiquitous. Wireless and automotive electronics are current examples. However, as means are developed to produce low cost and reliable devices, electronics will proliferate. Water vapor, corrosive gases and biological species can compromise the reliability of electronic products. One means to provide environmental protection for sophisticated internal electronics is to incorporate diffusion barrier capabilities within the, typically, plastic enclosure. Furthermore, many of these electronic products also require EMI shielding capability. As previously described, both diffusion barrier and EMI shielding capabilities can be provided by combining the advantages of extrusion and multiple layer film and/or sheet technology. Examples of such products are electronic enclosures such as network interface units as described in U.S. Patent Serial Number 08/537,372 (R.L. Decker, P. Hubbauer, W.R. Lambert, L. Shepherd, G.J. Shevchuk and J.D. Weld, *Weatherable Outside Electronic Device Enclosure,* filed October 2, 1995; incorporated herein by reference) and other small telecommunications equipment enclosures.

Other potential markets where the combined attributes of plastic extrusion and multiple layer film and/or sheet can be advantageous are in, for example, food containers such as cans. Impermeable, mechanically robust, plastic containers can be fabricated using extrusion and sophisticated multiple layer films to produce a low-cost alternative to metal cans. In both applications, it may be preferable to embed the multiple layer film within the body of the extruded part in order to ensure the integrity of the barrier layer during the life of the product.

### SUMMARY OF THE INVENTION

An object of the invention is to provide a method for applying a multiple layer sheet to the body of an extruded plastic part.

Another object of the invention is to provide a method for embedding a multiple layer sheet within the body of an extruded plastic part.

Another object of the invention is to provide a method for applying and embedding a multiple layer sheet within the body of an extruded plastic part which is cost effective and amenable to high volume production.

Another object of the invention is to provide a plastic part comprising an internal volume which is shielded from electromagnetic radiation by means of a surrounding metallized sheet layer.

Another object of the invention is to provide a part with superior diffusion barrier properties enhanced by using an embedded multiple layer film.

Another object of the invention is to provide a complex plastic part to which is applied a multiple layer sheet.

Another object of the invention is to provide a complex plastic part which incorporates an embedded multiple layer film.

To achieve these and other objects, the invention is directed to a sheet of material that provides diffusion barrier properties and electromagnetic shielding capability. The sheet is comprised of multiple layers of polymeric material selected for superior diffusion barrier propertied and at least one electrically conductive metallic layer to provide electromagnetic interference (EMI) shielding capabilities, as well as, to enhance the diffusion barrier properties. The sheet may also include layers intended to effect bonding. The multiple layer sheet is applied to the outer surface of a complex extruded plastic part. Alternatively, the multiple layer sheet is embedded within the body of a complex plastic part such that there exists an inner and outer plastic layer with the multiple layer sheet disposed between the inner and outer plastic layers.

To realize these structures, the invention is directed to the method for fabricating the part such that: 1) a structural base is extruded and exits the first extrusion die, 2) a multiple layer sheet is formed into a tube over the extruded structural base, 3) the multiple layer tube is pressed onto or otherwise conforms to the surface of the extruded base, 4) to embed the sheet within a part, the composite structure enters a second extrusion die, 5) a second layer of plastic material is extruded over the composite structure comprising the structural base and multiple layer sheet, 6) the continuous, completed complex part exits the second extrusion die, and 7) the complex part proceeds to subsequent finishing operations such as cooling and cutting. By this method a multiple layer sheet is applied to the surface of an extruded plastic structural part and can further be embedded within a complex extruded plastic part in a continuous process amenable to high volume production.

These and other aspects and advantages of the invention are described or apparent from the following detailed description of the preferred embodiments.

### BRIEF DESCRIPTION OF THE DRAWINGS

The preferred embodiments are described with reference to the drawings in which:

FIGURE 1 is a schematic view of the apparatus for the production of a complex extruded plastic part in accordance with the invention.

FIGURE 2 is a cross-sectional view of the complex extruded part comprising an embedded multiple layer film disposed between inner and outer polymer layers.

FIGURE 3 is a cross-sectional view of the multiple layer sheet of Figure 2.

### DETAILED DESCRIPTION OF THE PREFERRED EMBODIMENTS

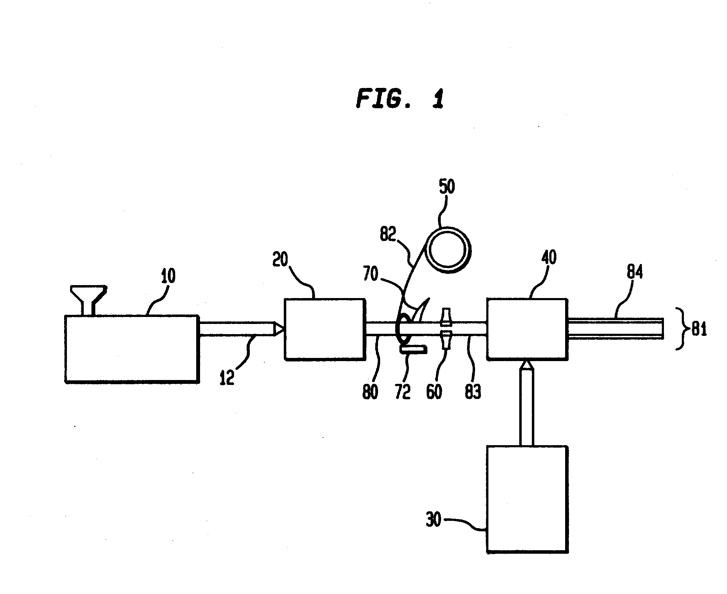

The invention is directed to a method of fabricating a complex, coextruded plastic part that includes a multiple layer sheet to either be applied to the surface of the part or embedded within the part. The part is fabricated in a manner illustrated in Figure 1. The base part 12 comprising a first material is processed by an extruder 10 and passed through an extrusion die 20 to form the first part 80. The shape of the first part 80 may comprise a complex internal structure with a preferably low profile exterior surface that would be shaped such as to facilitate conformance of the multiple layer sheet 82 in the subsequent processing step. The first part 80 leaves the first extrusion die 20 prior to application of the multiple layer sheet 82. The multiple layer sheet 82 is retained as a continuous roll on mandrel 50. The sheet 82 is formed into a tube by folding over collar or funnel 70 and seamed 72 in a continuous process. The seam 85 is formed by heat sealing or other such methods well known to those skilled in the art. Equipment to form the sheet 82 into a tubular structure is commonly employed in the packaging industry such as in the manufacture of flexible plastic bags. For example, the form/fill/seal equipment to form a tubular structure from flexible multiple layer sheet stock can be obtained from *Key-Pak Machines of Research and Development Packaging Corporation* of Lebanon, New Jersey. The flexible tube formed from the multiple layer sheet 82 is fitted around the first extruded part 80 and compressed against the surface of the first part 80 with rollers 60. The rollers 60 may be heated depending upon the materials comprising the first part 80, the composition of the sheet 82, and the heat of the extruded part at the location of the rollers 60. The shape of the rollers 60 is such that it conforms to that of the outer surface of the first part 60. In this manner, the multiple layer tube is bonded to the surface of the first part 80 to produce part 83 comprising a plastic extruded part with a bonded external multiple layer sheet.

Alternatively, to produce a part in which the multiple layer sheet is embedded within the body of the extruded part, the first part 80, including the outer multiple layer sheet 82, as part 83, then enters a second extrusion die 40 where a second part or material 84 is extruded using conventional extrusion equipment 30 onto the composite structure. The coextruded part 81 including the embedded multiple layer sheet 82 exit the second extrusion stage. The complex coextruded part 81 then proceeds to subsequent cutting, packaging, etc., operations (not shown).

The first part 80 and second part 84 may comprise any material which is extrudable and are preferably polymeric materials. The first part 80 and the second part 84 may comprise the same or different materials. Such materials may include, but are not limited to such polymers as styrenes, acrylonitrile, butadiene, acrylates, polycarbonates, polyolefins, nylons, thermoplastic elastomers, polyurethanes, polysulfones, polyacetals, polyphenylene oxide based resins, polyvinyl chloride and polyesters including copolymers and/or blends of these resins. The thickness of the first part 80 and second part 84 is determined by the application. It is desirable that the first part 80 formed from the desired material be sufficiently thick so as to provide structural rigidity to enable the subsequent processing steps.

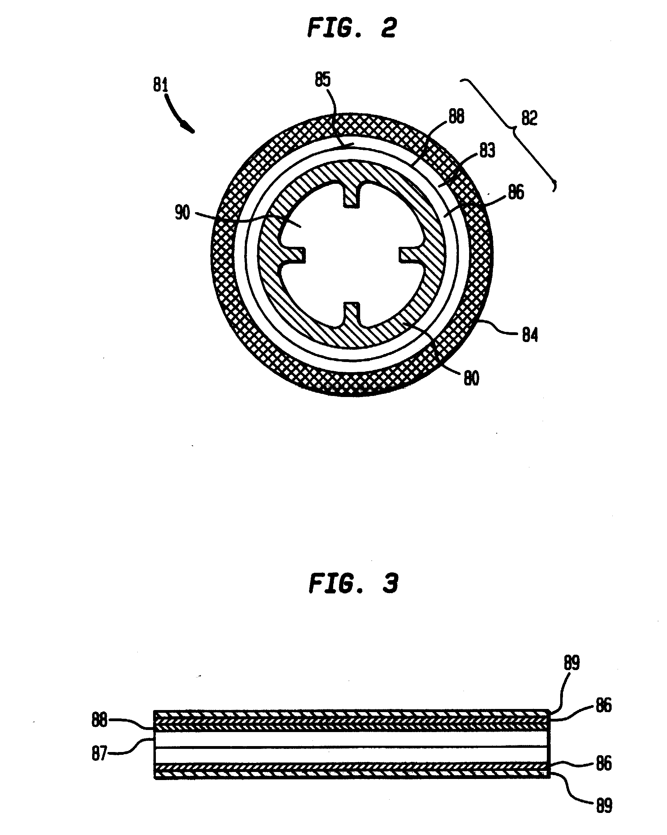

A preferred embodiment of a coextruded part 81 comprising an embedded multiple layer sheet is illustrated in Figure 2. In this embodiment, the first part 80, for example, exhibits a complex structure and provides for an open interior volume 90. The multiple layer sheet 82 comprises an inner polymeric layer 86, an outer polymer layer 83 and a metallic layer 88 situated between plastic layers 86 and 83. The seam 85 that was created as the sheet 82 was formed into a tubular structure is shown to be folded flat. The seam 85 may be formed between polymeric layers or between the metal layer 88 to provide enhanced EMI shielding capability and diffusion barrier properties. For superior EMI shielding and diffusion barrier properties it is desirable that the seam be formed as a metal-to-metal bond.

A preferred embodiment of the multiple layer sheet 82 is illustrated in Figure 3. The multiple layer sheet 82 may contain at least one layer 87 of polymeric material selected for superior diffusion barrier properties and at least one single metallic layer 88 to impart both EMI shielding capability, as well as, enhanced diffusion barrier properties. In order to provide superior diffusion barrier properties, the metallic layer 88 is preferably a foil greater than 0.35 mils thick and is substantially free of pinholes. To provide additional barrier protection, more than one metallic layer (not shown) may be incorporated into the sheet 82. The metallic layer 88 is preferably made from aluminum due to the low cost and availability. However, it should be understood that other metals and alloys such as copper, nickel, and the like may also be used. For EMI shielding capability, the metallic layer 88 can exhibit an electrical resistance of at least less than 1 Ω/square. The material composition of the polymeric layers 87 are determined by the superior diffusion barrier properties to corrosive gases, water vapor, oxygen, nitrogen, carbon dioxide, biological species and the like and are comprised of, but not limited to, materials such as polyolefins, fluorinated hydrocarbons such as Teflon® polyesters, liquid crystal polymers, ionomers such as SURLYN®, polyvinylidene chloride, ethylene vinyl alcohol copolymer, nitrite polymers, nylons, etc. Alternatively, when diffusion barrier properties are not required for the application, other plastic materials, preferably similar to or the same as those comprising the first and second part can be used. The outer surfaces of the multiple layer sheet 82 may be preferably comprised of an adhesive layer 89 which facilitates bonding the sheet to both the first 80 and second 84 extruded polymeric parts or materials. To ensure integral bonding between the multiple layer sheet 82 and the first and second extruded parts, 80 and 84, it may be desirable to have the surfaces of the multiple layer sheet 82 be of the same polymeric material as the extruded polymeric materials to which they are to be bonded. The bonding may bc accomplished by physical or chemical means. Considering that the first part 80 is elevated extrusion temperatures when the sheet 82 is applied to the surface of the first part 80, the bonding process is preferably heat activated. In a similar manner, the sheet 82 is by nature of the coextrusion process bonded to the second polymeric material 84 by heat and pressure applied to the composite part within the second extrusion die 40. In addition, the polymeric materials comprising the multiple layer sheet 82 are preferably selected such that they do not substantially deform at the temperatures existing during the second extrusion process.

While this invention has been described in conjunction with specific embodiments, it is evident that many alternatives, modifications and variations will be apparent to those skilled in the art. Accordingly, the preferred embodiments of this invention as set forth herein are intended to be illustrative, rather than limiting. Various changes may be made without departing from the spirit and scope of the invention as defined in the following claims.

## Claims

1. A method for fabricating a complex coextruded part providing diffusion barrier properties and electromagnetic interference shielding capabilities, comprising the steps of:
extruding a first part made of a first material;
providing a sheet of material including a multiple layer sheet;
forming a tubular structure from the sheet of material around the first part;
bonding the tubular structure onto a surface of the first part forming a composite structure; and
extruding a second part made of a second material over the composite structure, thereby forming the complex coextruded part,
whereby the multiple layer film provides enhanced barrier properties and electromagnetic interference shielding capabilities to the complex coextruded part.

2. The method according to claim 1, wherein the first and/or second materials comprises plastic or polymeric material(s).

3. The method according to claim 2, wherein the first material is made from a consisting of materials which include, but not limited to, such polymers as styrenes, acrylonitrile, butadiene, acrylates, polycarbonates, polyolefins, nylons, thermoplastic elastomers, polyurethanes, polysulfones, polyacetals, polyphenylene oxide based resins, polyvinyl chloride and polyesters including copolymers and/or blends of these resins.

4. The method according to claim 2 or 3, wherein the first and/or second material(s) is/are made from materials which include, such polymers as styrenes, acrylonitrile, butadiene, acrylates, polycarbonates, polyolefins, nylons, thermoplastic elastomers, polyurethanes, polysulfones, polyacetals, polythenylene oxide based resins, polyvinyl chloride and polyesters including copolymers and/or blends of these resins.

5. The method according to claim 1, wherein the multiple layer sheet comprises at least one metallic layer, and/or at least one polymeric layer.

6. The method according to claim 1, wherein the multiple layer sheet is bonded either by a heat activated mechanism, or by one of physical and chemical means.

7. The method according to claim 1, wherein the first part provides for an open interior volume.

8. A complex part comprising extruded plastic and a multiple layer sheet for providing diffusion barrier properties and electromagnetic interference capabilities, the sheet comprising:
at least one layer of polymeric material for providing diffusion barrier properties;
at least one layer of metallic film for providing electromagnetic interference shielding capabilities; and
wherein the sheet is formed into a tubular structure with a continuous seam to provide diffusion barrier properties and electromagnetic interference shielding capabilities to the part.

9. The sheet according to claim 8, wherein the at least one layer of polymeric material(s) selected from such polymers as styrenes, acrylonitrile, butadiene, acrylates, polycarbonates, polyolefins, nylons, thermoplastic elastomers, polyurethanes, polysulfones, polyacetals, polythenylene oxide based resins, polyvinyl chloride and polyesters including copolymers and/or blends of these resins, or polymeric materials selected from polyolefins, fluorinated hydrocarbons such as Teflon®, polyester, liquid crystal polymers, ionomers such as SURLYN®, polyvinylidene chloride, ethylene vinyl alcohol copolymer, nitride polymers, nylons, etc.

10. The sheet according to claim 8, wherein the at least one layer of metallic sheet comprises a foil having a thickness greter than 0.35 mils and which is substantially free of pinholes.

11. The sheet according to claim 8, wherein the at least one layer of metallic film provides an electrical resistance of at least 1 Ω/square.
